# EUROPÄISCHE PATENTSCHRIFT

(11) **EP 0 636 866 B1**
(45) Veröffentlichungstag und Bekanntmachung des Hinweises auf die Patenterteilung: **27.01.1999**
(21) Anmeldenummer: 94110646.0
(22) Anmeldetag: 08.07.1994
(51) Int. Cl.: G01K 7/01

(54) **Verfahren und Schaltungsanordnung zur Messung der Sperrschichttemperatur eines GTO-Thyristors**
Method and circuit arrangement for measuring the temperature of a barrier layer of a GTO thyristor
Méthode et montage de circuit pour mesurer la température de la couche barrière d'un thyristor GTO

(30) Priorität: 26.07.1993 DE 4324982
(43) Veröffentlichungstag der Anmeldung: 01.02.1995
(73) Patentinhaber: ASEA BROWN BOVERI AG, 5400 Baden (CH)
(72) Erfinder: Hauswirth, Christian, CH-5235 Rüfenach (CH); Hochstuhl, Gerhard, D-79761 Waldshut-Tiengen 1 (DE); Hofstetter, Bruno, CH-5200 Brugg (CH); Keller, Markus, CH-4708 Luterbach (CH)

(56) Entgegenhaltungen:
- EP-A- 0 217 620
- MEASUREMENT TECHNIQUES, Bd.18, Nr.1, Januar 1975, NEW YORK US Seiten 153 - 154 V.A. BUN'KO E.A. 'DEVICE FOR DETERMINING THE THRYRISTOR CRYSTAL TEMPERATURE'

## Beschreibung

### Technisches Gebiet

Die Erfindung bezieht sich auf das Gebiet der Leistungselektronik.

Sie betrifft ein Verfahren zur Messung der Sperrschichttemperatur eines GTO-Thyristors. Im weiteren geht sie aus von einer Schaltungsanordnung gemäss dem Oberbegriff des vierten Anspruchs.

### Stand der Technik

Verschiedene Verfahren und Vorrichtungen zur Temperaturmessung von GTOs werden z.B. im Normierungsvorschlag IEC 747-6 von 1983 angegeben. Diesen Verfahren ist gemeinsam, dass die Sperrschichttemperatur des GTOs nur über den Umweg des inneren thermischen Widerstandes errechnet werden kann.

Zu diesem Zweck muss sowohl dieser Wert als auch die Temperatur und die Verlustleistung der GTOs durch zusätzliche Messeinrichtungen gemessen werden. Aus den errechneten Werten kann jedoch nur näherungsweise auf die tatsächliche Siliziumtemperatur des GTOs geschlossen werden.

Damit ist man aber stets im Ungewissen, wie hoch der GTO thermisch tatsächlich belastet wird.

Ein weiteres Verfahren welches zur Messung der Siliziumtemperatur des Thyristors geeignet ist, wird in "Measurement techniques", Bd. 18(1), p.153-154 (1975) dargelegt. Darin wird im Maximum der negativen (gesperrten) Halbwelle ein Mess-Puls an den Gatekreis angelegt. Aus dem resultierenden Spannungsabfall zwischen Gate und Kathode wird auf die Sperrschichttemperatur geschlossen.

### Darstellung der Erfindung

Aufgabe der vorliegenden Erfindung ist es deshalb, ein Verfahren und eine Schaltungsanordnung zur Messung der Sperrschichttemperatur eines GTOs anzugeben, wobei die Messung direkt am GTO und im Betrieb möglich sein soll.

Diese Aufgabe wird bei einem Verfahren bzw. einer Vorrichtung der eingangs genannten Art durch die Merkmale des ersten bzw. vierten Anspruchs gelöst.

Kern des erfindungsgemässen Verfahrens ist es also, dass nach Abschalten des GTO im Gatekreis ein Messstrom mit der gleichen Polarität wie der Ausschaltsteuerstrom eingeprägt wird und nach Abklingen des letzteren die Spannung zwischen Kathode und Gate des GTOs gemessen wird.

Diese Spannung weist je nach Sperrschichttemperatur des Siliziums einen bestimmten Wert auf. Deshalb kann aus dieser Spannungsmessung direkt auf die Sperrschichttemperatur des GTOs geschlossen werden.

Ein bevorzugtes Ausführungsbeispiel dieses Verfahrens zeichnet sich dadurch aus, dass ein konstanter Strom von ca. 100 mA eingeprägt wird.

Der Kern der erfindungsgemässen Schaltungsanordnung besteht darin, dass eine spezielle Vorrichtung vorgesehen ist, welche einen Messstrom eingeprägt.

In einem bevorzugten Ausführungsbeispiel umfasst die Vorrichtung eine Stromquelle zwischen dem Gate und der Kathode des GTO sowie eine Vorrichtung zur Messung der Spannung zwischen Gate und Kathode. Die Stromquelle wird dabei von einer Speisespannungsquelle, welche ebenfalls im Pfad "Gate-Kathode" angeordnet ist, gespeist.

Der GTO wird durch eine Ansteuerschaltung, bestehend aus einem Einschaltkreis und einem Ausschaltkreis, angesteuert. Die erfindungsgemässe Vorrichtung ist mit dem Ausschaltkreis parallel geschaltet. Um eine elektrische Entkopplung zu erreichen, kann eine Diode zwischen dem Ausschaltkreis und der erfindungsgemässen Vorrichtung vorgesehen werden.

Weitere Ausführungsbeispiele ergeben sich aus den Unteransprüchen.

Die Vorteile des erfindungsgemässen Verfahrens bzw. der Schaltungsanordnung liegen insbesondere darin, dass aus der gemessenen Spannung direkt auf die Silizium-Sperrschichttemperatur des GTOs geschlossen werden kann. Die Messung kann zudem während des Betriebs der Anlage vorgenommen werden. Dadurch und da die Messung direkt am Element erfolgt wird es erstmals möglich, die Belastung des GTOs direkt über die Silizium-Temperatur zu regeln.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine erfindungsgemässe Schaltungsanordnung zur Messung der Sperrschichttemperatur eines GTO;
- **Fig. 2**: Den Verlauf des Gate-Stromes und der Spannung zwischen Kathode und Gate beim Abschalten des GTOs in Abhängigkeit der Zeit;
- **Fig. 3**: Die Abhängigkeit der gemessenen Spannung von der Silizium-Sperrschichttemperatur des GTOs.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

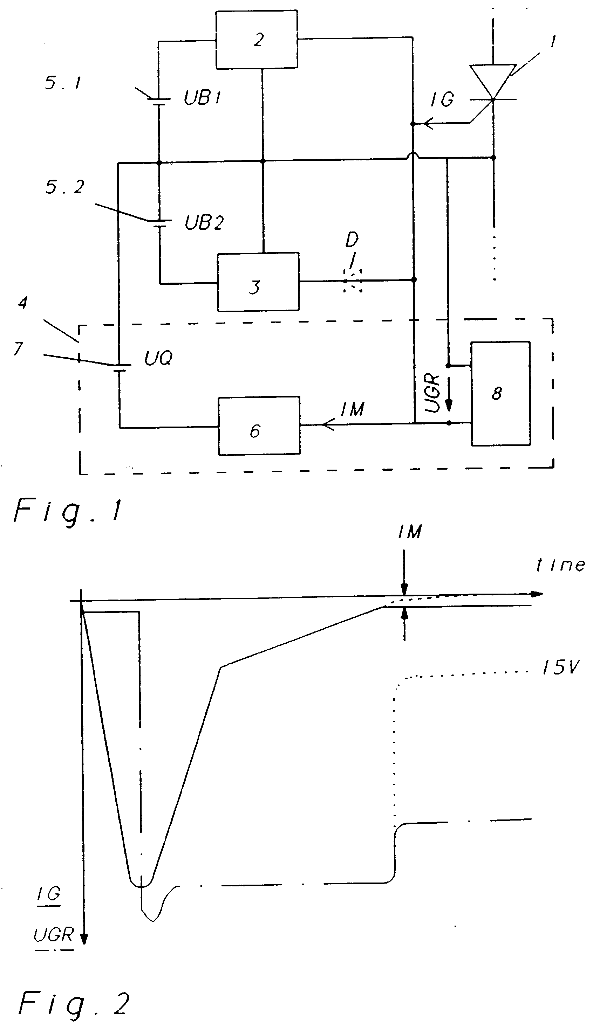

Figur 2 zeigt den zeitlichen Verlauf des Gatestroms und der Spannung zwischen Kathode und Gate beim Abschalten eines GTO. Nach dem Abschalten sinkt der Strom (I_{G}) auf Null ab (strichliert angedeutet). Dieses Verhalten ist wohl bekannt und bedarf deshalb keiner weiterer Erläuterungen.

Die Spannung zwischen Kathode und Gate (U_{GR}) steigt zum Zeitpunkt des Gatestrommaximums rasch an, überschwingt ein wenig und sinkt, nachdem der Strom (I_{GR}) gegen Null gesunken ist, wieder ab. Üblicherweise wird die Spannung (U_{GR}) anschliessend von aussen auf einem konstanten Wert von beispielsweise 15 V gehalten (punktierter Spannungsverlauf).

Nach der Erfindung wird nun ein Messstrom (I_{M}) in den Gatekreis eingeprägt. Demzufolge klingt der Strom (I_{G}) nicht mehr auf Null ab, sondern bleibt nach dem Abschaltvorgang auf einem Wert (I_{M}) stehen. Dadurch ändert sich auch der Verlauf der Spannung (U_{GR}). Sie bleibt auf einem höheren Endwert stehen (strich-punktiert).

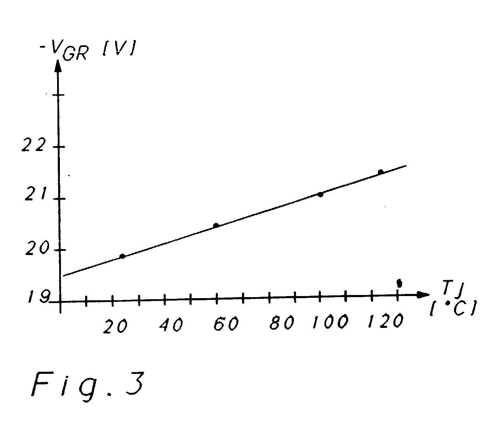

Wie **Figur 3** zeigt, ändert sich dieser Endwert der Spannung (U_{GR}) linear mit der Sperrschichttemperatur des GTOs. Im Versuchsaufbau mit einem Messstrom von ca. 100 mA wurde ein Gradient von ca. 16.5 mV/K bis 16.7 mV/K je nach GTO-Typ gemessen. Damit kann anhand der gemessenen Spannung präzise und auf einfache Weise auf die Silizium-Sperrschichttemperatur des GTOs geschlossen werden.

Vorteilhafterweise wird die Spannung erst nach dem Abklingen der transienten Abschaltvorgänge gemessen. Danach hat die Spannung in der Regel einen stationären, nur noch von der Sperrschichttemperatur anhängigen Wert erreicht.

**Figur 1** zeigt eine Schaltungsanordnung mit einem GTO (1), welcher auf konventionelle Weise z.B. mit einem Einschaltkreis (2) und einem Ausschaltkreis (3) angesteuert wird. Der GTO (1) kann beispielsweise Teil einer Anlage mit mehreren GTOs sein. Der Einschaltkreis (2) ist für das Zünden des GTOs (1) zuständig, der Ausschaltkreis (3) für das Abschalten. Ein- und Ausschaltkreis (2, 3) werden von den Speisespannungsquellen (5.1, 5.2) gespeist. Sowohl der Einschaltkreis (2) als auch der Ausschaltkreis (3) ist zwischen Gate und Kathode des GTOs geschaltet. Ihre Funktionsweise wird als bekannt vorausgesetzt und hier nicht mehr weiter erläutert.

Für die Erfindung wesentlich ist die strichliert umrandete Vorrichtung (4). Mit dieser Vorrichtung (4) kann die Sperrschichttemperatur des GTOs im Betrieb und in der Anlage, zu welcher der GTO gehört, gemessen werden.

Die Vorrichtung (4) ist parallel zum Ein- und Ausschaltkreis (2,3) geschaltet und umfasst im wesentlichen eine Stromquelle (6), eine Vorrichtung (8) zur Messung der Kathoden-Gate-Spannung (U_{GR}) sowie eine Speisespannungsquelle (7) zur Spannungsversorgung der Stromquelle (6).

Mit dieser Vorrichtung (4) ist es möglich, den Messstrom (I_{M}) einzuprägen und gleichzeitig die Spannung (V_{GR}) zwischen Kathode und Gate des GTOs zu messen. Um die Vorrichtung (4) vom Ausschaltkreis (3) zu entkoppeln und ein Fehlzünden des GTOs durch grosse dU/dt-Werte zu verhindern, kann zudem eine Diode (D) zwischen dem Gate und dem Ausschaltkreis (3) vorgesehen werden.

Wie im Zusammenhang mit dem erfindungsgemässen Verfahren erläutert wurde, gibt die Stromquelle z.B. einen Strom (I_{M}) von ca. 100 mA ab, und die Spannung (U_{GR}) wird eine bestimmte Zeit nach dem Abschalten gemessen. Wesentlich beim Messzeitpunkt ist nur, dass die Spannung (U_{GR}) einen stabilen Endwert erreicht hat, derart, dass sie nur noch vom Messstrom (I_{M}) und von der Sperrschichttemperatur des GTOs abhängt.

Mit dem erfindungsgemässen Verfahren und der dazu geeigneten Vorrichtung ist es also erstmals möglich, die Sperrschichttemperatur des GTOs direkt am Element, ohne Umwege über z.B. Messung der Kühlkörpertemperatur o.ä., und vor allem auch während des Betriebs zu messen. Damit wird es möglich, die Anlage in Abhängigkeit von der thermischen Belastung der GTOs zu regeln.

### Bezeichnungsliste

- 1: GTO
- 2: Einschaltkreis
- 3: Ausschaltkreis
- 4: Vorrichtung zur Messung der Sperrschichttemperatur des GTO
- 5.1, 5.2: Speisespannungsquellen für Ein- und Ausschaltkreis
- 6: Stromquelle
- 7: Speisespannungsquelle für die Vorrichtung 4
- 8: Vorrichtung zur Messung der Gate-Kathoden-Spannung
- U_{B1}, U_{B2}, U_{Q}: Speisespannungen
- U_{GR}: Spannung zwischen Gate und Kathode
- I_{M}: Messstrom
- I_{G}: Gatestrom

## Patentansprüche

1. Verfahren zur Messung der Sperrschichttemperatur eines GTO-Thyristors, welcher als Halbleiterschalter in einer Anlage eingesetzt wird und einen Laststromkreis und einen Gatekreis aufweist, wobei der Laststrom durch den GTO ein- und ausgeschaltet werden kann, indem der Gatekreis mit einem Steuerstrom beaufschlagt wird, wobei
a) im Gatekreis ein verglichen mit der Ausschaltsteuerstrom kleiner Messstrom gleicher Polarität eingeprägt wird;
b) nach dem Abschalten des GTOs und nachdem transiente Abschaltvorgänge abgeklungen sind eine Spannung (U_{GR}) zwischen Kathode und Gate des GTOs gemessen wird; und
c) anhand der gemessenen Spannung (U_{GR}) auf die Sperrschichttemperatur (Tj) des GTO geschlossen wird.

2. Verfahren nach Anspruch 1, dadurch gekennzeichnet, dass ein Messstrom (I_{M}) von ca. 100 mA eingeprägt wird.

3. Verfahren nach Anspruch 1 oder 2, dadurch gekennzeichnet, dass der Messstrom (I_{M}) nach dem Abschalten des GTOs mindestens einmal und für eine bestimmte Messzeitdauer eingeprägt wird.

4. Schaltungsanordnung mit mindestens einem GTO (1), dessen Gate und Kathode mit einer Ansteuerschaltung, bestehend aus einem Ein- (2) und einem Ausschaltkreis (3), verbunden ist, wobei der GTO (1) als Halbleiterschalter in einer Anlage eingesetzt wird und einen Laststromkreis und einen Gatekreis aufweist, wobei der Laststrom durch den GTO ein- und ausgeschaltet werden kann, indem der Gatekreis mit einem Steuerstrom beaufschlagt wird, mit einer Vorrichtung (4), mittels welcher im Gatekreis ein verglichen mit der Ausschaltsteuerstrom kleiner Messstrom gleicher Polarität eingeprägt wird und mit welcher die Spannung U_{GR} zwischen Kathode und Gate des GTO gemessen wird.

5. Schaltungsanordnung nach Anspruch 4, dadurch gekennzeichnet, dass die Vorrichtung (4) zwischen Gate und Kathode des GTOs angeordnet ist und eine Stromquelle (6) sowie eine weitere Vorrichtung (8) zur Messung einer Kathoden-Gate-Spannung (U_{GR}) umfasst.

6. Schaltungsanordnung nach Anspruch 5, dadurch gekennzeichnet, dass die weitere Vorrichtung (8) die Spannung (U_{GR}) zwischen Kathode und Gate nach dem Abschalten des GTOs misst, sobald der Gatestrom (I_{G}) auf den Messstrom (I_{M}) abgesunken ist.

7. Schaltungsanordnung nach Anspruch 6, dadurch gekennzeichnet, dass der Ein- und Ausschaltkreis (2, 3) und die Stromquelle (6) von je einer Spannungsquelle (5.1, 5.2 bzw. 7) gespeist werden.

8. Schaltungsanordnung nach Anspruch 7, dadurch gekennzeichnet, dass zwischen dem Ausschaltkreis (3) und dem Gate des GTO mindestens eine Diode (D) derart angeordnet ist, dass die Messvorrichtung (4) vom Ausschaltkreis (3) elektrisch entkoppelt ist.

9. Schaltungsanordnung nach Anspruch 8, dadurch gekennzeichnet, dass die Stromquelle (6) einen kleinen Strom von ca. 100 mA abgibt.

## Claims

1. Method for measuring the depletion layer temperature of a GTO thyristor which is used as a semiconductor switch in an installation and has a load circuit and a gate circuit, it being possible to switch the load current on and off by means of the GTO by applying a control current to the gate circuit, characterized in that
a) a measurement current which is small in comparison to the switching-off control current and is of the same polarity being impressed in the gate circuit;
b) after the GTO has been turned off and once any transient turn-off processes have decayed, a voltage (U_{GR}) being measured between the cathode and gate of the GTO; and
c) the measured voltage (U_{GR}) being used to deduce the depletion layer temperature (Tⱼ) of the GTO.

2. Method according to Claim 1, characterized in that a measurement current (I_{M}) of approximately 100 mA is impressed.

3. Method according to Claim 1 or 2, characterized in that, once the GTO has been turned off, the measurement current (I_{M}) is impressed at least once and for a specific measurement time duration.

4. Circuit arrangement having at least one GTO (1) whose gate and cathode are connected to a drive circuit comprising a switching-on circuit (2) and a switching-off circuit (3), the GTO (1) being used as a semiconductor switch in an installation and having a load circuit and a gate circuit, it being possible to switch the load current on and off by means of the GTO by applying a control current to the gate circuit, and having a device (4) by means of which a measurement current which is small in comparison to the switching-off control current and is of the same polarity is impressed in the gate circuit and with which the voltage U_{GR} is measured between the cathode and gate of the GTO.

5. Circuit arrangement according to Claim 4, characterized in that the device (4) is arranged between the gate and cathode of the GTO and comprises a current source (6) and a further device (8) for measuring a cathode-gate voltage (U_{GR}).

6. Circuit arrangement according to Claim 5, characterized in that the further device (8) measures the voltage (U_{GR}) between the cathode and gate after the GTO has been turned off and as soon as the gate current (I_{G}) has fallen to the measurement current (I_{M}).

7. Circuit arrangement according to Claim 6, characterized in that the switching-on circuit (2) and switching-off circuit (3) and the current source (6) are supplied from in each case one voltage source (5.1, 5.2 and 7).

8. Circuit arrangement according to Claim 7, characterized in that at least one diode (D) is arranged between the switching-off circuit (3) and the gate of the GTO in such a manner that the measurement device (4) is electrically decoupled from the switching-off circuit (3).

9. Circuit arrangement according to Claim 8, characterized in that the current source (6) emits a small current of approximately 100 mA.

## Revendications

1. Méthode pour mesurer la température de la couche barrière d'un thyristor GTO qui est utilisé en tant que commutateur semi-conducteur dans un équipement et qui présente un circuit de courant de charge et un circuit de gâchette, le courant de charge pouvant être allumé et éteint par le GTO en appliquant un courant de commande au circuit de gâchette,
a) un courant de mesure de même polarité et inférieur au courant de commande d'extinction étant appliqué dans le circuit de gâchette ;
b) une tension (UGR) étant mesurée entre la cathode et la gâchette du GTO après l'extinction du GTO et après disparition des phénomènes transitoires de l'extinction ; et
c) la température de la couche barrière (TJ) du GTO étant déduite au moyen de la tension mesurée (UGR).

2. Méthode selon la revendication 1, caractérisée par le fait que le courant de mesure (IM) appliqué est d'environ 100 mA.

3. Méthode selon la revendication 1 ou 2, caractérisée par le fait que le courant de mesure (IM) est appliqué après l'extinction du GTO au moins une fois et pendant une durée de mesure donnée.

4. Montage de circuit comprenant au moins un GTO (1) dont la gâchette et la cathode sont reliés par un circuit de commande composé d'un circuit d'allumage (2) et d'un circuit d'extinction (3), le GTO (1) étant utilisé en tant que commutateur semi-conducteur dans un équipement et présentant un circuit de courant de charge et un circuit de gâchette, le courant de charge pouvant être allumé et éteint par le GTO en appliquant un courant de commande au circuit de gâchette, muni d'un dispositif (4) qui permet d'appliquer un courant de mesure de même polarité et inférieur au courant de commande d'extinction dans le circuit de gâchette et qui permet de mesurer la tension UGR entre la cathode et la gâchette du GTO.

5. Montage de circuit selon la revendication 4, caractérisé par le fait que le dispositif (4) est disposé entre la gâchette et la cathode du GTO et qu'il comprend une source de courant (6) et un autre dispositif (8) pour mesurer une tension cathode - gâchette (UGR).

6. Montage de circuit selon la revendication 5, caractérisé par le fait que l'autre dispositif (8) mesure la tension (UGR) entre la cathode et la gâchette après l'extinction du GTO dès que le courant de gâchette (IG) a chuté au niveau du courant de mesure (IM).

7. Montage de circuit selon la revendication 6, caractérisé par le fait que les circuits d'allumage et d'extinction (2, 3) et la source de courant (6) sont chacun alimentés par une source de tension (5.1 , 5.2 ou 7).

8. Montage de circuit selon la revendication 7, caractérisé par le fait qu'au moins une diode (D) est disposée entre le circuit d'extinction (3) et la gâchette du GTO de manière à découpler électriquement le dispositif de mesure (4) du circuit d'extinction (3).

9. Montage de circuit selon la revendication 8, caractérisé par le fait que la source de courant (6) délivre un faible courant d'environ 100 mA.
